# EUROPEAN PATENT APPLICATION

(11) **EP 4 746 029 A1**
(43) Date of publication of application: **20.05.2026**
(21) Application number: 24839252.4
(22) Date of filing: 28.03.2024
(51) Int. Cl.: H01L 21/52, H01L 21/60

(54) **MOUNTING DEVICE AND MOUNTING METHOD**

(30) Priority: 10.07.2023 JP 2023112832
(71) Applicant: Yamaha Robotics Co., Ltd., Musashimurayama-shi, Tokyo 208-8585 (JP)
(72) Inventor: SAITO, Takashi, Chikuma-shi, Nagano 389-0898 (JP); NOMURA, Yudai, Chikuma-shi, Nagano 389-0898 (JP)
(74) Representative: Becker, Eberhard
(86) International application number: PCT/JP2024/012887
(87) International publication number: WO 2025/013354

(57) **Abstract**

A mounting device (1) is provided with: a first mold (10) configured to hold substrates (SB1, SB2) on which electronic components (CH11, CH12, CH21, CH22) are placed; a second mold (20) disposed facing the first mold (10); and a gas supply mechanism for supplying an inert gas. The second mold (20) has movable mechanisms (22A, 22B, 22C, 22D) and elastic elements (23A, 23B, 23C, 23D). The electronic components (CH11, CH12, CH21, CH22) are pressurized by the movable mechanisms (22A, 22B, 22C, 22D) in accordance with the elastic force of the elastic elements (23A, 23B, 23C, 23D) in a state in which the first mold (10) and the second mold (20) are closed.

## Description

### Technical Field

The invention relates to a mounting device and a mounting method.

### Related Art

A mounting device is known that simultaneously pressurizes multiple electronic components onto at least one substrate when mounting the electronic components on the substrate via a bonding material. In such mounting device, each of the electronic components may be individually pressurized so that mounting defects do not occur due to an insufficient or excessive pressure on the electronic components resulting from the differences in dimensions among the electronic components.

For example, Patent Document 1 discloses a semiconductor mounting device that includes multiple pressing blocks for individually pressurizing multiple semiconductor elements, multiple shafts for linearly moving the pressing blocks, multiple pressure blocks for pressurizing the blocks via the shafts, and an elastic body for collectively pressurizing the pressure blocks. The pressure blocks are pressurized by supplying an air pressure or a compressed gas pressure to a pressure valve and expanding the elastic body toward the side of the pressure blocks.

### Prior Art Document(s)

### Patent Document(s)

[Patent Document 1] Japanese Patent Application Laid-Open Publication No. 2002-110744

### SUMMARY OF INVENTION

### Technical Problem

However, the semiconductor mounting device described in Patent Document 1 needs to include a compressor or a high-pressure tank for supplying the air pressure or the compressed gas pressure, and a piping for passing air or compressed gas. Therefore, the size of the device may be large.

The invention has been made in view of such circumstances, and an object thereof is to provide a compact mounting device capable of suppressing the occurrence of mounting defects and a mounting method using the same.

### Solution to Problem

A mounting device according to an aspect of the invention is a mounting device for mounting one or more electronic components on at least one substrate and includes: a first mold, configured to hold the substrate on which the electronic component is placed; a second mold, disposed opposite to the first mold; and a gas supply mechanism, supplying inert gas to a space between the first mold and the second mold. The second mold includes a movable mechanism and an elastic element, and, in a state where the first mold and the second mold are closed, the electronic component is pressurized by the movable mechanism according to an elastic force of the elastic element.

A mounting method according to another aspect of the invention is a mounting method using a mounting device for mounting one or more electronic components on at least one substrate and includes: preparing a first mold configured to hold the substrate on which the electronic component is placed; and preparing a second mold disposed opposite to the first mold. In addition, the second mold has a movable mechanism and an elastic element. The mounting method further includes: supplying an inert gas to a space between the first mold and the second mold; closing the first mold and the second mold; and in a state where the first mold and the second mold are closed, pressurizing the electronic component by the movable mechanism according to an elastic force of the elastic element.

### [Inventive effects]

According to the invention, it is possible to provide a compact mounting device capable of suppressing mounting defects from occurring and a mounting method using the same.

### BRIEF DESCRIPTION OF DRAWINGS

[FIG. 1] FIG. 1 is a view showing an overall schematic configuration of a mounting device according to an embodiment of the invention.
[FIG. 2] FIG. 2 is a flowchart showing a portion of a mounting method according to an embodiment of the invention.
[FIG. 3] FIG. 3 is a flowchart showing a portion of the mounting method according to an embodiment of the invention.
[FIG. 4] FIG. 4 is a graph showing a temperature profile of the mounting method according to an embodiment of the invention.
[FIG. 5] FIG. 5 is a view showing the mounting device in one step of the mounting method.
[FIG. 6] FIG. 6 is a view showing the mounting device in one step of the mounting method.
[FIG. 7] FIG. 7 is a view showing the mounting device in one step of the mounting method.
[FIG. 8] FIG. 8 is a view showing the mounting device in one step of the mounting method.
[FIG. 9] FIG. 9 is a view showing the mounting device in one step of the mounting method.

### DESCRIPTION OF EMBODIMENTS

Embodiments of the invention are described below. In the following description of the drawings, the same or similar components are represented by the same or similar reference numerals. The drawings are illustrative, and the dimensions, shapes, and numbers of the respective components are schematic, and the technical scope of the invention should not be construed as being limited to the embodiments.

### <Mounting device>

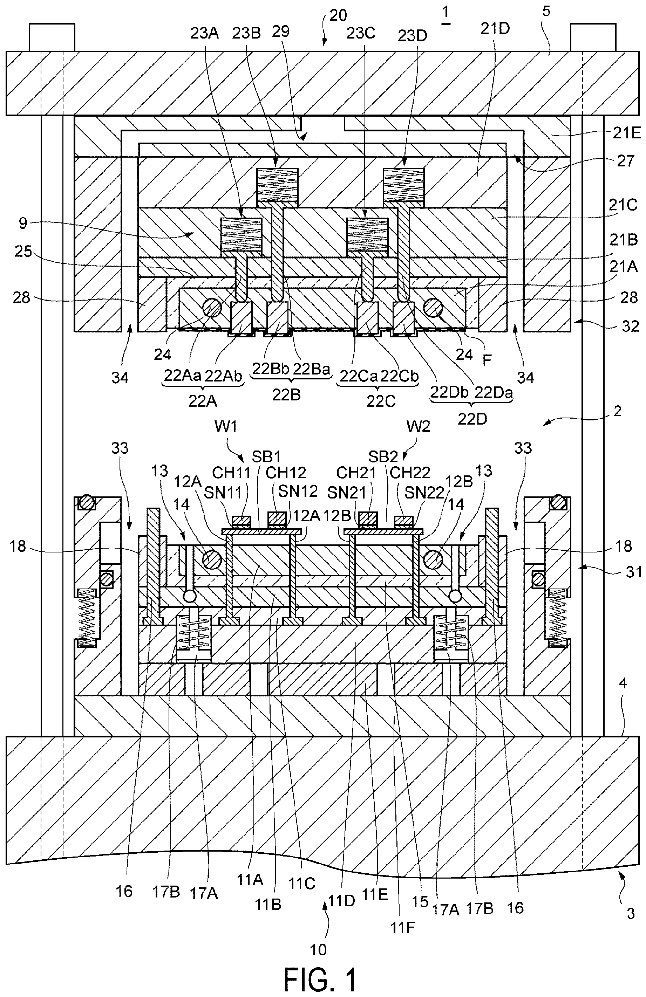

First, the configuration of a mounting device 1 according to an embodiment of the invention is described with reference to FIG. 1. FIG. 1 is a view showing an overall schematic configuration of the mounting device according to an embodiment of the invention.

The mounting device 1 performs a mounting process on workpieces W1, W2. The workpiece W1 includes electronic components CH11, CH12, bonding materials SN11, SN12, and a substrate SB1. The workpiece W2 includes electronic components CH21, CH22, bonding materials SN21, SN22, and a substrate SB2. That is, the mounting device 1 mounts the electronic component CH11 on the substrate SB1 via the bonding material SN11, mounts the electronic component CH12 on the substrate SB1 via the bonding material SN12, mounts the electronic component CH21 on the substrate SB2 via the bonding material SN21, and mounts the electronic component CH22 on the substrate SB2 via the bonding material SN22. Inside the mounting device 1, the workpiece W1 is disposed, so that the substrate SB1 opposes a lower mold 10 and the electronic components CH11, CH12 oppose an upper mold 20, and the workpiece W2 is disposed, so that the substrate SB2 opposes the lower mold 10, and the electronic components CH21, CH22 oppose the upper mold 20. Before the mounting process is performed by the mounting device 1, the electronic components CH11, CH12 are placed on the substrate SB1, and the electronic components CH21, CH22 are disposed on the substrate SB2. After the mounting process is performed by the mounting device 1, the electronic components CH11, CH12 are bonded to the substrate SB1, and the electronic components CH21, CH22 are bonded to the substrate SB2. In the following description, the side where the electronic components CH11, CH12, CH21, CH22 are provided is referred to as the front surfaces of the substrates SB1, SB2, and the opposite side is referred to as the back surfaces of the substrates SB1, SB2.

The electronic components CH11, CH12, CH21, CH22 are, for example, semiconductor chips. The substrates SB1, SB2 are direct bonded aluminum (DBA) substrates (high heat dissipation ceramic insulating substrates with aluminum circuits) or direct bonded copper (DBC) substrates (high heat dissipation ceramic insulating substrates with copper circuits), but the invention is not limited thereto. The bonding materials SN11, SN12, SN21, SN22 are, for example, sintering materials containing silver (Ag) nanoparticles. The mounting device 1 is a sintering device that sinters the bonding materials SN11, SN12, SN21, SN22 by heating and pressurizing. The height of each of the substrates SB1, SB2 is, for example, different from each other, but may also be the same. The height of each of the electronic components CH11, CH12 is, for example, different from each other, but may also be the same. The height of each of the electronic components CH21, CH22 is, for example, different from each other, but may also be the same. The thickness of each of the bonding materials SN11, SN12, SN21, SN22 may be of the same height. Additionally, the number of electronic components for one substrate is at least one and is not limited to two.

The mounting device according to an embodiment of the invention is not limited to a sintering device, as long as the mounting pressurizes electronic components, and may be an appropriate device such as a flip chip bonder. Additionally, the electronic component according to an embodiment of the invention is not limited to a semiconductor chip, and may be, for example, a passive element such as a resistor, an inductor, a capacitor, or a crystal oscillator, or may be an active element such as a diode, a transistor, a thyristor, or an operational amplifier.

The substrate according to an embodiment of the invention is not limited to a ceramic substrate, and may be, for example, a semiconductor substrate such as a silicon substrate, a metal substrate such as a lead frame, or an insulator substrate such as a printed circuit board (PCB) substrate. While two electronic components are mounted on the substrate, the electronic components may also be arranged into a matrix with multiple columns and multiple rows. Additionally, the substrate may be an electronic component, and in this case, the mounting device according to an embodiment of the invention is a device that bonds electronic components to each other. The bonding material according to an embodiment of the invention is not limited to a sintering material, and may be a semi-sintering material, a metal solder, an organic adhesive, or an inorganic adhesive. The form of the bonding material is, for example, an aggregate of powder, but may be liquid, semi-solid, solid, or film-like.

The number of substrates according to an embodiment of the invention is not limited to two, and may be at least one. Similarly, the number of electronic components is not limited to four, and at least one may be provided on one substrate.

As shown in FIG. 1, the mounting device 1 includes a press device 3 and a mold 2 attached to the press device 3. In the illustrated example, the mounting device 1 further includes degassing chambers 31, 32. The press device 3 includes a pair of upper and lower platens 4, 5 connected by tie bars.

The mold 2 includes an upper mold base 21E fixed to the upper platen 5 and a lower mold base 11F fixed to the lower platen 4. Main plates (support plates 21D, 21C, upper mold chase 21B, lower mold chase 11B, ejector pin plate 11C, retainer plate 11D, etc.) forming the mold 2 are fixed between the upper mold base 21E and the lower mold base 11F.

In the following description, the various plates fixed to the lower mold base 11F and the components thereof are collectively referred to as the lower mold 10, and the various plates fixed to the upper mold base 21E and the components thereof are collectively referred to as the upper mold 20. The lower mold 10 is an example of "first mold," and the upper mold 20 is an example of "second mold."

The lower mold 10 mainly includes the lower mold base 11F, support pillars 11E, the retainer plate 11D, the ejector pin plate 11C, the lower mold chase 11B, and the like. It is fixed above the lower mold base 11F via the support pillars 11E protruding in a columnar shape from the lower mold base 11F.

The ejector pin plate 11C and the retainer plate 11D are disposed below the lower mold chase 11B. In the ejector pin plate 11C and the retainer plate 11D, holes through which the support pillars 11E penetrate are provided. The ejector pin plate 11C and the retainer plate 11D are fixed to each other and are configured to be vertically slidable between the lower mold chase 11B and the lower mold base 11F.

Various components including a cavity plate 11A are fixed to the lower mold chase 11B. In the illustrated example, the cavity plate 11A, a side block 18 for fixing the cavity plate 11A, a heat insulation member 15 disposed to surround the lower and side surfaces of the cavity plate 11A, and springs 17B and spring sleeves 17A are fixed to the lower mold chase 11B.

Multiple lifter pins 12A, 12B capable of protruding from and retracting into the cavity plate 11A, and set pins 16, etc., that abut against the upper mold 20 when the mold is clamped, are fixed to the ejector pin plate 11C and the retainer plate 11D.

The cavity plate 11A is provided at a position closest to the upper mold 20 and contacts the space between the lower mold 10 and the upper mold 20 when the mold is open. A heater 14 is provided inside the cavity plate 11A. When the lower mold 10 and the upper mold 20 are closed, the heater 14 heats the substrates SB1, SB2 via the cavity plate 11A. As a result, the bonding materials SN11, SN12, SN21, SN22 are heated.

The heat insulation member 15 is provided between the cavity plate 11A and the lower mold chase 11B, and between the cavity plate 11A and the side block 18. The heat insulation member 15 suppresses direct thermal conduction from the cavity plate 11A to the lower mold chase 11B, and suppresses thermal conduction from the cavity plate 11A to the lower mold chase 11B via the side block 18.

In other words, the heat insulation member 15 is disposed to separate the gas piping provided in the lower mold chase 11B and the heater 14, and suppresses the temperature rise of the nitrogen gas supplied from the gas supply port 13. Additionally, the heat insulation member 15 is disposed to separate the spring 17B and the heater 14, and suppresses the decrease in the elastic force of the spring 17B. That is, the heat insulation member 15 limits the heating target to the cavity plate 11A, thereby accelerating the temperature rise by the heater 14 and making other members less susceptible to the influence of heat.

The side block 18 is provided on the side of the lower mold chase 11B that opposes the upper mold 20. When viewed in a plan view from the upper mold 20, the side block 18 is provided on the outer side of the cavity plate 11A. The side block 18 abuts against the upper mold 20 when the lower mold 10 and the upper mold 20 are closed.

The gas supply port 13 supplies gas such as nitrogen (N2) gas toward the electronic components CH11, CH12, CH21, CH22 and the substrates SB1, SB2. In the illustrated example, a gas supply port 13 for supplying gas such as nitrogen (N2) gas is provided on the side of the heat insulation member 15 outer with respect to the heater 14 of the cavity plate 11A. The gas supply port 13 is provided on the surface of the cavity plate 11A that opposes the upper mold 20, and opens toward the upper mold 20. Therefore, the gas supply port 13 rapidly removes oxidizing gas from around the workpieces W1, W2 during heating, and places the workpieces W1, W2 in a nitrogen atmosphere.

Additionally, the gas supply port 13 performs gas-cooling of the workpieces W1, W2 by directing nitrogen gas at the workpieces W1, W2 during cooling. When viewed in a plan view from the upper mold 20, multiple gas supply ports 13 are provided on the outer side of the workpieces W1, W2. The gas piping through which the nitrogen gas supplied by the gas supply ports 13 passes is provided in the lower mold chase 11B. The gas supply port 13 is an example of "gas supply mechanism" that supplies inert gas to the space between the lower mold 10 and the upper mold 20.

The inert gas supplied by the gas supply port is not limited to nitrogen gas, and may be, for example, carbon dioxide, fluorocarbon, or noble gas. Additionally, the gas supply port may be open toward an electronic component, a bonding material, or a substrate, and may blow inert gas directly onto the electronic component, the bonding material, or the substrate. The gas supply port may be provided in the upper mold, or may be provided in both the lower mold and the upper mold. The gas supply port may be provided in the side blocks 18, 28 of at least one of the lower mold and the upper mold, or may be provided in a degassing chamber to be described later. Inert gas and degassing are not necessarily required.

The spring 17B biases the ejector pin plate 11C and the retainer plate 11D (moves the ejector pin plate 11C and the retainer plate 11D upward) toward the lower mold chase 11B. The spring sleeve 17A has a base end part (upper end part) that is a shoulder bolt (or a washer, a sleeve, and a bolt), and is fixed to the lower surface of the lower mold chase 11B. A flange (which has a nail head shape with an expanded diameter) is provided at the tip end part (lower end part) of the spring sleeve 17A.

The retainer plate 11D has a through hole formed therein that is larger than the tip end part of the spring sleeve 17A. A counterbore larger than the tip end part of the spring sleeve 17A and a through hole larger than the base end part of the spring sleeve 17A are formed in the ejector pin plate 11C. The spring sleeve 17A is inserted through the through hole of the retainer plate 11D and the through hole of the ejector pin plate 11C.

The spring 17B is provided in a helical shape around the spring sleeve 17A between the flange of the spring sleeve 17A and the counterbore of the ejector pin plate 11C. In other words, the spring sleeve 17A is inserted into the helical spring 17B. The spring 17B exerts an elastic force in a direction that separates the ejector pin plate 11C and the flange at the tip end part of the spring sleeve 17A from each other.

In other words, the spring 17B biases the ejector pin plate 11C and the retainer plate 11D toward the lower mold chase 11B via the spring sleeve 17A. The spring 17B is an example of an elastic member, and the elastic member is not limited to a spring, as long as the elastic force described above can be exerted. The elastic member may be, for example, rubber or a leaf spring.

The lifter pins 12A, 12B are inserted through the inside of the through holes that penetrate the cavity plate 11A, the lower mold chase 11B, the ejector pin plate 11C, and the heat insulation member 15. The lifter pins 12A, 12B have the same length, and three or four or more lifter pins are used to hold the workpiece W1 in parallel. The side of the upper mold 20 is defined as the tip end part, and the side of the lower mold base 11F is defined as the base end part. The base end parts of the lifter pin 12B and the set pin 16 are sandwiched between the ejector pin plate 11C and the retainer plate 11D and are screwed in place. The lifter pin 12B and the set pin 16 move up and down in conjunction with the ejector pin plate 11C and the retainer plate 11D.

The lifter pin 12A supports the substrate SB1 by bringing the tip end part of the lifter pin 12A into contact with the back surface of the substrate SB1, and the lifter pin 12B supports the substrate SB2 by bringing the tip end part of the lifter pin 12B into contact with the back surface of the substrate SB2. The lifter pins 12A, 12B are configured to be able to adjust the distance between the substrates SB1, SB2 and the cavity plate 11A, and bring the substrates SB1, SB2 and the cavity plate 11A into contact with and away from each other.

Specifically, the lifter pins 12A, 12B are configured to be able to advance and retract from the cavity plate 11A toward the upper mold 20. When the lifter pins 12A, 12B are advanced into the space between the lower mold 10 and the upper mold 20 (during mold opening), the workpieces W1, W2 supported by the lifter pins 12A, 12B are separated from the cavity plate 11A. When the lifter pins 12A, 12B are retracted from the space between the lower mold 10 and the upper mold 20 (during mold closing), the workpieces W1, W2 are supported in contact with the cavity plate 11A.

When the ejector pin plate 11C and the retainer plate 11D approach (move upward toward) the cavity plate 11A, the tip end parts of the lifter pins 12A, 12B protrude from the cavity plate 11A. That is, the lifter pins 12A, 12B are advanced into the space between the lower mold 10 and the upper mold 20.

When the ejector pin plate 11C and the retainer plate 11D move away from (move downward from) the cavity plate 11A, the tip end parts of the lifter pins 12A, 12B are housed inside the cavity plate 11A. That is, the lifter pins 12A, 12B are retracted from the space between the lower mold 10 and the upper mold 20. The lifter pins 12A, 12B are an example equivalent to "holding part". The holding part is not limited to lifter pins. The holding part may be an elongated plate-shaped member that holds the end part of the workpiece.

The set pin 16 is inserted through a through hole that penetrates the side block 18, the lower mold chase 11B, and the ejector pin plate 11C. The set pin 16 has a tip end part on the side of the upper mold 20 and a base end part on the side of the lower mold base 11F. The base end part of the set pin 16 is sandwiched between the ejector pin plate 11C and the retainer plate 11D. The tip end part of the set pin 16 faces a side block 28 of the upper mold 20.

When the lower mold 10 and the upper mold 20 are closed, the set pin 16 is pressed by the side block 28 and pushes down the ejector pin plate 11C and the retainer plate 11D. By pushing down the ejector pin plate 11C and the retainer plate 11D, the lifter pin 12B is pushed down in conjunction therewith, causing the substrates SB1, SB2 on the lifter pins 12B to move downward. In addition, in order to push down the ejector pin plate 11C and the retainer plate 11D in parallel, it is preferable that approximately four set pins 16 are disposed at the four corners of the workpiece.

The upper mold 20 mainly includes the upper mold base 21E, the upper support plate 21D, the lower support plate 21C, the upper mold chase 21B, a pressure regulating mechanism 9, and the like. The upper support plate 21D and the lower support plate 21C are fixed to the upper mold base 21E. The upper mold chase 21B is fixed to the upper mold base 21E via the upper support plate 21D and the lower support plate 21C.

Various components including the cavity plate 21A are fixed to the upper mold chase 21B. In the illustrated example, the upper mold chase 21B is provided with the cavity plate 21A, the side block 28 that fixes the cavity plate 21A, a heat insulation member 25 disposed to surround the upper surface and the side surfaces of the cavity plate 21A, and a portion of the pressure regulating mechanism 9.

The cavity plate 21A is provided at a position closest to the lower mold 10. A heater 24 is provided inside the cavity plate 21A. The heater 24 heats movable pieces 22Ab, 22Bb, 22Cb, 22Db described later via the cavity plate 21A. When the lower mold 10 and the upper mold 20 are closed, the heater 24 heats the electronic components CH11, CH12, CH21, CH22 via the movable pieces 22Ab, 22Bb, 22Cb, 22Db and the film F. In this way, the bonding materials SN11, SN12, SN21, SN22 are heated.

The side block 28 is provided on a side of the upper mold chase 21B opposing the lower mold 10. When viewed in a plan view from the upper mold 20, the side block 28 is provided on the outer side of the cavity plate 21A. The side block 28 is a portion of the upper mold 20 that contacts the lower mold 10 when the lower mold 10 and the upper mold 20 are closed. That is, when the lower mold 10 and the upper mold 20 are closed, the side block 28 contacts the set pin 16.

The heat insulation member 25 is provided between the cavity plate 21A and the upper mold chase 21B, and is provided between the cavity plate 21A and the side block 28. The heat insulation member 25 suppresses the direct thermal conduction from the cavity plate 21A to the upper mold chase 21B, and suppresses the thermal conduction from the cavity plate 21A to the upper mold chase 21B via the side block 28.

The heat insulation member 25 partitions the heater 24 and the upper mold chase 21B, thereby suppressing thermal degradation of springs 23A, 23B, 23C, 23D to be described later. That is, the heat insulation member 25 limits the heating target to the cavity plate 21A, thereby accelerating the temperature rise by the heater 24 and making other members less susceptible to the influence of heat.

When performing the mounting process, a film F is stretched on a surface of the cavity plate 21A opposing the lower mold 10. A suction hole (not shown) for suctioning the film F is provided on the lower surface of the cavity plate, and adsorbs the film F. The suction hole is connected to an external vacuum suction pump and controls ON and OFF of adsorption.

As an example of the film F, a film material excellent in heat resistance, ease of peeling, flexibility, and extensibility is suitably used, such as polytetrafluoroethylene (PTFE), ethylene-tetrafluoroethylene (ETFE) copolymer, polyethylene terephthalate (PET), tetrafluoroethylene-hexafluoropropylene (FEP) copolymer, fluorine-impregnated glass cloth, polypropylene (PP), polyvinylidene chloride (PVDC), etc.

The film F inhibits the intrusion of powder and gas generated from the bonding materials SN11, SN12, SN21, SN22 into the gap of the upper mold 20, and suppresses the malfunctioning of the upper mold 20. In addition, the film F serves as a cushioning material between the movable pieces 22Ab, 22Bb, 22Cb, 22Db and the electronic components CH11, CH12, CH21, CH22, and has an effect of suppressing damages to the electronic components CH11, CH12, CH21, CH22 during pressurization.

The pressure regulating mechanism 9 absorbs the difference in thickness between the substrates SB1, SB2, the difference in height among the electronic components CH11, CH12, CH21, CH22, and the difference in thickness among the bonding materials SN11, SN12, SN21, SN22, and pressurizes the bonding materials SN11, SN12, SN21, SN22 with substantially uniform pressure. The pressure regulating mechanism 9 includes movable mechanisms 22A, 22B, 22C, 22D and the springs 23A, 23B, 23C, 23D.

The movable mechanism 22B is provided closest to the movable mechanism 22A. The movable mechanism 22D is provided closest to the movable mechanism 22C. Similarly, the spring 23B is provided closest to the spring 23A. The spring 23D is provided closest to the spring 23C.

The movable mechanism 22A is connected to the spring 23A and configured to be movable in the upper-lower direction. Similarly, the movable mechanism 22B is connected to the spring 23B and configured to be movable in the upper-lower direction, the movable mechanism 22C is connected to the spring 23C and configured to be movable in the upper-lower direction, and the movable mechanism 22D is connected to the spring 23D and configured to be movable in the upper-lower direction.

Regarding rod-shaped members such as the movable mechanisms 22A, 22B, 22C, 22D in the upper mold 20, the side of the upper mold base 21E is defined as the base end part, and the side of the lower mold 10 is defined as the tip end part. The base end part of the movable mechanism 22A receives the elastic force of the spring 23A, and the tip end part of the movable mechanism 22A pressurizes the electronic component CH11 based on the elastic force of the spring 23A. As a result, the bonding material SN11 is pressurized by the movable mechanism 22A via the electronic component CH11. Similarly, the movable mechanism 22B pressurizes the electronic component CH12 based on the elastic force of the spring 23B, and the bonding material SN12 is pressurized by the movable mechanism 22B via the electronic component CH12. The movable mechanism 22C pressurizes the electronic component CH21 based on the elastic force of the spring 23C, and the bonding material SN21 is pressurized by the movable mechanism 22C via the electronic component CH21. The movable mechanism 22D pressurizes the electronic component CH22 by the elastic force of the spring 23D, and the bonding material SN22 is pressurized by the movable mechanism 22D via the electronic component CH22.

The movable mechanism 22A includes a rod 22Aa and a movable piece 22Ab. The movable mechanism 22B includes a rod 22Ba and a movable piece 22Bb. The movable mechanism 22C includes a rod 22Ca and a movable piece 22Cb. The movable mechanism 22D includes a rod 22Da and a movable piece 22Db.

The rod 22Aa is provided at the base end part of the movable mechanism 22A. The rod 22Aa is provided to be slidable relative to the cavity plate 21A, the upper mold chase 21B, the heat insulation member 25, and the lower support plate 21C. The base end part of the rod 22Aa is disposed inside a concave part that opens toward the side of the upper mold chase 21B of the lower support plate 21C, and is provided in a nail head shape with an expanded diameter larger than the tip end part of the rod 22Aa. The base end part of the rod 22Aa is configured to be slidable relative to the lower support plate 21C, and the limit of downward movement is defined by the upper mold chase 21B. The tip end part of the rod 22Aa is disposed inside a through hole that penetrates the cavity plate 21A, the upper mold chase 21B, and the heat insulation part 25, and the foremost end of the tip end part of the rod 22Aa is rounded in a bullet shape. In the rod 22Aa, the foremost base end of the base end part is connected to the spring 23A, and the foremost end of the tip end part is in point contact with the movable piece 22Ab. The rod 22Aa transmits the upper-lower movement of the movable piece 22Ab to the spring 23A, and transmits the elastic force generated in the spring 23A to the movable piece 22Ab.

The movable piece 22Ab is provided at the tip end part of the movable mechanism 22A. The movable piece 22Ab is provided to be slidable relative to the cavity plate 21A. The tip end part of the movable piece 22Ab protrudes from the cavity plate 21A. The base end part of the movable piece 22Ab is located inside the cavity plate 21A and is connected to the tip end part of the rod 22Aa. The movable piece 22Ab is a movable insert that moves in the upper-lower direction and is prevented from falling. When the lower mold 10 and the upper mold 20 are closed, the tip end part of the movable piece 22Ab contacts the upper surface of the electronic component CH11 via the film, and applies the pressure of the spring 23A transmitted via the rod 22Aa to the electronic component CH11.

The rod 22Ba is provided at the base end part of the movable mechanism 22B. The rod 22Ba is provided to be slidable relative to the cavity plate 21A, the upper mold chase 21B, the heat insulation member 25, the lower support plate 21C, and the upper support plate 21D. The base end part of the rod 22Ba is disposed inside a concave part that opens toward the side of the lower support plate 21C of the upper support plate 21D, and is provided in a nail head shape with an expanded diameter larger than the tip end part of the rod 22Ba. The base end part of the rod 22Ba is configured to be slidable relative to the upper support plate 21D, and the limit of downward movement is defined by the lower support plate 21C. The tip end part of the rod 22Ba is disposed inside a through hole that penetrates the cavity plate 21A, the upper mold chase 21B, the heat insulation member 25, and the lower support plate 21C, and the foremost end of the tip end part of the rod 22Ba is rounded in a bullet shape. In the rod 22Ba, the foremost base end of the base end part is connected to the spring 23B, and the foremost end of the tip end part is in point contact with the movable piece 22Bb. The rod 22Ba transmits the upper-lower movement of the movable piece 22Ab to the spring 23B, and transmits the elastic force generated in the spring 23B to the movable piece 22Ab.

The structure and the function of the rod 22Ca are similar to the structure and the function of the rod 22Aa. The structure and the function of the rod Da are similar to the structure and the function of the rod 22Ba. The structure and the function of the movable pieces 22Bb, 22Cb, and 22Db are similar to the structure and the function of the movable piece 22Ab. Therefore, the description of the rods 22Ca and 22Da and the movable pieces 22Bb, 22Cb, and 22Db is omitted.

At the time of performing the mounting process, the side of the movable pieces 22Ab, 22Bb, 22Cb, and 22Db that contacts the electronic components CH11, CH12, CH21, and CH22 is covered by a continuous film F. The film F prevents dust generated from the bonding materials SN11, SN12, SN21, and SN22 from adhering to and contaminating the upper mold 20, and mitigates damages to the chips CH11, CH12, CH21, and CH22.

The movable piece 22Ab that contacts the electronic component CH11 via the film F is pushed up based on the thicknesses of the substrate SB1, the bonding material SN11, and the electronic component CH11. The pushed-up movable piece 22Ab pushes up the rod 22Aa and compresses the spring 23A to generate an elastic force. The elastic force generated by the spring 23A is transmitted by the rod 22Aa and applied to the electronic component CH11 by the movable piece 22Ab. Similarly, the movable piece 22Bb is pushed up based on the thicknesses of the substrate SB1, the bonding material SN12, and the electronic component CH12, and applies the elastic force generated by the spring 23B to the electronic component CH12. The movable piece 22Cb is pushed up based on the thicknesses of the substrate SB2, the bonding material SN21, and the electronic component CH21, and applies the elastic force generated by the spring 23C to the electronic component CH21. The movable piece 22Db is pushed up based on the thicknesses of the substrate SB2, the bonding material SN22, and the electronic component CH22, and applies the elastic force generated by the spring 23D to the electronic component CH22.

The springs 23A, 23B, 23C, and 23D act independently of each other. Therefore, the pressure applied to the electronic component CH11 is not affected by the springs 23B, 23C, and 23D, and is determined only by the elastic force of the spring 23A. The pressure applied to the electronic component CH12 is not affected by the springs 23A, 23C, and 23D, and is determined only by the elastic force of the spring 23B. The pressure applied to the electronic component CH21 is not affected by the springs 23A, 23B, and 23D, and is determined only by the elastic force of the spring 23C. The pressure applied to the electronic component CH22 is not affected by the springs 23A, 23B, and 23C, and is determined only by the elastic force of the spring 23D. The difference in thickness between the substrates SB1 and SB2, the difference in height among the electronic components CH11, CH12, CH21, and CH22, and the difference in thickness among the bonding materials SN11, SN12, SN21, and SN22 are absorbed by the springs 23A, 23B, 23C, and 23D, and the bonding materials SN11, SN12, SN21, and SN22 are pressurized with a substantially equal pressure.

The springs 23A, 23B, 23C, and 23D generate elastic forces in a direction to push down the movable mechanisms 22A, 22B, 22C, and 22D by being compressed in the upper-lower direction. The springs 23A, 23B, 23C, and 23D are coil springs formed using a metal material. The springs 23A and 23C are provided inside concave parts open toward the side of the upper mold chase 21B of the lower support plate 21C. The springs 23B and 23D are provided inside concave parts open toward the side of the lower support plate 21C of the upper support plate 21D. In the opening and closing direction of the lower mold 10 and the upper mold 20, a gap is present between the spring 23A and the spring 23B. Also, in the opening and closing direction of the lower mold 10 and the upper mold 20, a gap is present between the spring 23C and the spring 23D. That is, the base end parts of the springs 23A and 23C are provided closer to the side of the lower mold 10 than the tip end parts of the springs 23B and 23D. When viewed in a plan view from the lower mold 10, portions of the springs 23A and 23B overlap each other, and portions of the springs 23C and 23C overlap each other with a gap therebetween. The springs 23A, 23B, 23C, and 23D move the movable mechanisms 22A, 22B, 22C, and 22D based on the elastic forces. The springs 23A, 23B, 23C, and 23D are an example of "elastic elements".

The elastic elements are not limited to coil springs as long as elastic forces can be generated in a direction to push down the movable mechanisms 22A, 22B, 22C, and 22D. The elastic elements may be, for example, rubber or leaf springs.

The degassing chambers 31, 32 are vacuum chambers that are openable and closable and surround the lower mold 10 and the upper mold 20. The degassing chamber 31 is connected to the lower mold base 11F of the lower mold 10. When viewed in a plan view from the upper mold 20, the degassing chamber 31 is provided on the outer side of the side block 18. A degassing path 33 through which the degassing gas passes is provided between the degassing chamber 31 and the lower mold chase 11B, the ejector pin plate 11C, the retainer plate 11D, the support pillar 11E, and the side block 18. The degassing chamber 32 is connected to the upper mold base 21E of the upper mold 20. When viewed in a plan view from the lower mold 10, the degassing chamber 32 is provided on the outer side of the side block 28. A degassing path 34 through which the degassing gas passes is provided between the degassing chamber 32 and the upper mold chase 21B, the lower support plate 21C, the upper support plate 21D, and the side block 28. The degassing path 34 is connected to a degassing path 27 provided in the upper mold base 21E. The degassing path 27 is connected to a degassing port 29 provided in the upper mold base 21E. The degassing port 29 is connected to a vacuum pump outside the mold. With the degassing port 29, the atmosphere of the lower mold 10 and the upper mold 20 in the degassing chambers 31, 32 is degassed.

### <Mounting method>

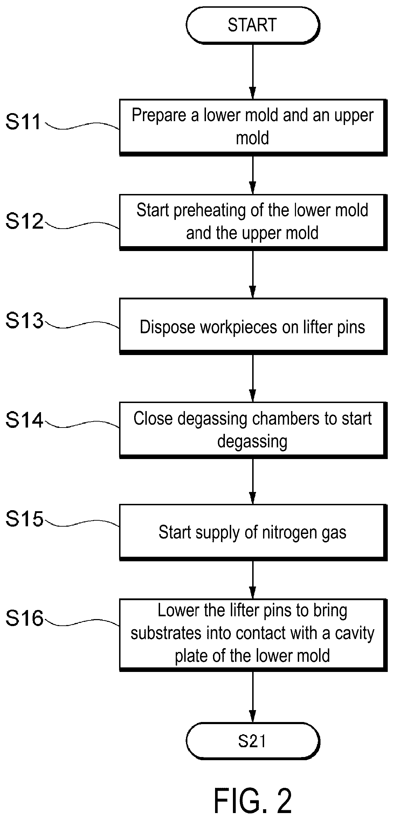

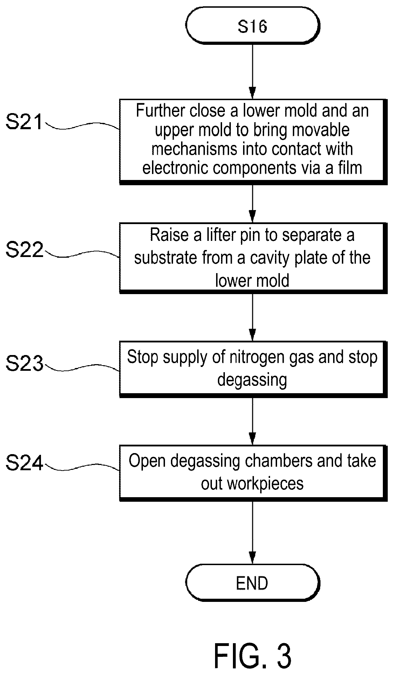

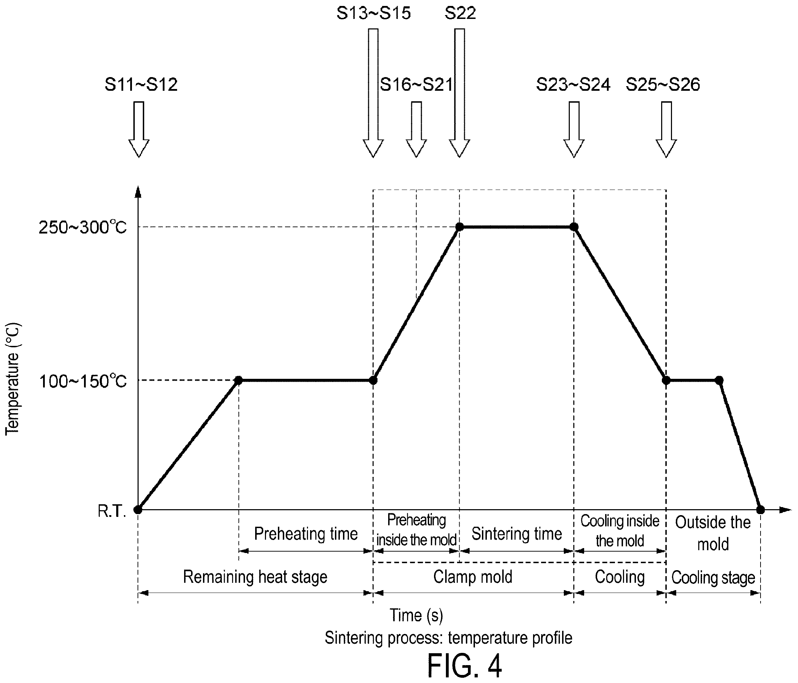

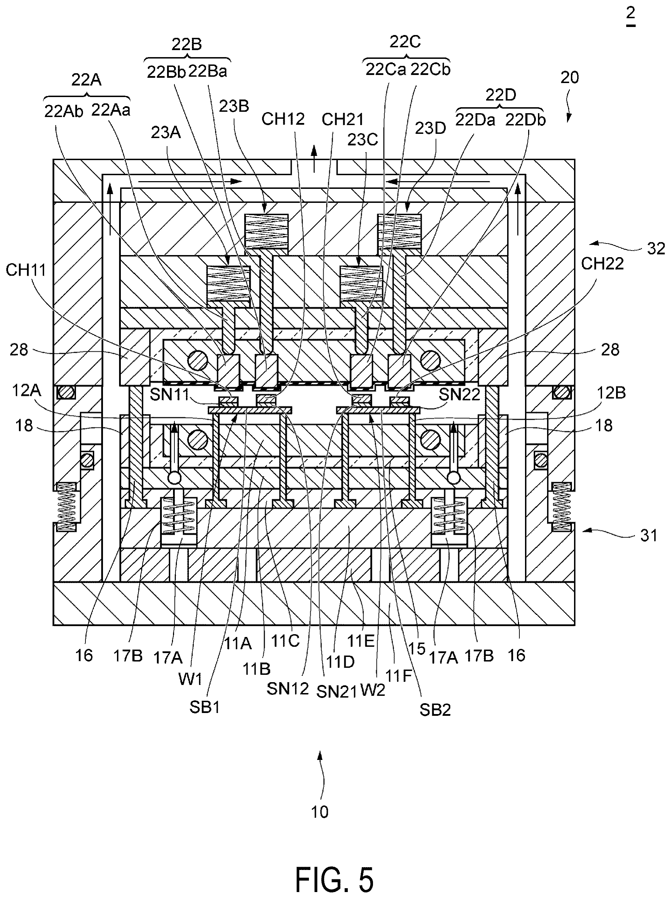

Next, a mounting method using the mounting device 1 according to the embodiment will be described with reference to FIG. 2 to FIG. 9. FIG. 2 and FIG. 3 are flowcharts showing portions of the mounting method according to an embodiment of the invention. FIG. 4 is a graph showing a temperature profile of the mounting method according to an embodiment of the invention. FIG. 5 to FIG. 9 are views showing the mounting device at one step of the mounting method. In the graph of FIG. 4, the horizontal axis indicates time, and the vertical axis indicates the temperature of the workpiece.

First, the lower mold 10 and the upper mold 20 are prepared (S11), and preheating of the lower mold 10 and the upper mold 20 is started (S12). As shown in FIG. 4, the temperature of the workpieces W1, W2 at this time is room temperature (R.T.).

Next, the workpieces W1, W2 are disposed on the lifter pins 12A, 12B (S13). In the workpiece W1, the electronic components CH11 and CH12 are placed on the substrate SB1. In the workpiece W2, the electronic components CH21 and CH22 are placed on the substrate SB2. Next, the degassing chambers 31, 32 are closed to start degassing (S14), and the supply of nitrogen gas is started (S15). Before raising the temperature of the bonding materials SN11, SN12, SN21, SN22 to the sintering process temperature, degassing is performed and, by making the atmosphere around the bonding materials SN11, SN12, SN21, and SN22 a nitrogen gas atmosphere, the bonding materials SN11, SN12, SN21, and SN22 are suppressed from oxidization. As shown in FIG. 5, when the degassing chambers 31, 32 are closed, the tip end part of the set pin 16 abuts against the side block 28 of the upper mold 20. The side blocks 18, 28 of the lower mold 10 and the upper mold 20 are spaced apart from each other, and the workpieces W1, W2 are spaced apart from the cavity plate 11A. The substrates SB1, SB2 are heated by thermal radiation from the cavity plate 11A of the lower mold 10. The electronic components CH11, CH12, CH21, CH22 are heated by thermal radiation from the movable pieces 22Ab, 22Bb, 22Cb, 22Db of the upper mold 20. As shown in FIG. 4, the temperature of the workpieces W1, W2 at this time is approximately 100°C to 150°C.

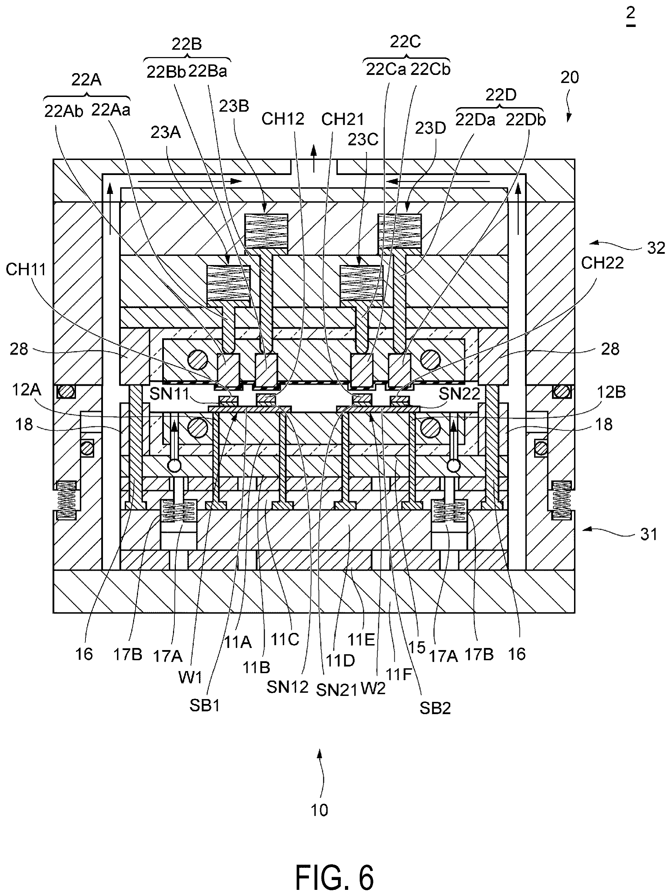

Next, the mold closes a little further, the lifter pins 12A, 12B are lowered, and the substrates SB1, SB2 are brought into contact with the cavity plate 11A of the upper mold 20 (S16). As shown in FIG. 6, with the lower mold 10 and the upper mold 20 approaching each other, the set pin 16 is pushed down by the side block 28 of the upper mold 20. The set pin 16 that is pushed down pushes down the ejector pin plate 11C and the retainer plate 11D connected to the base end part of the set pin 16. The ejector pin plate 11C and the retainer plate 11D that are pushed down push down the lifter pins 12A, 12B whose base end parts are connected to the ejector pin plate 11C and the retainer plate 11D. As a result, the workpieces W1, W2 contact the cavity plate 11A. The substrates SB1, SB2 are heated by the thermal conduction from the cavity plate 11A of the lower mold 10, and the electronic components CH11, CH12, CH21, CH22 are heated by thermal radiation from the movable pieces 22Ab, 22Bb, 22Cb, 22Dd of the upper mold 20. As shown in FIG. 4, the temperature of the workpieces W1, W2 at this time is raised from the preheating temperature of 100°C to 150°C to the sintering process temperature of 250°C to 300°C.

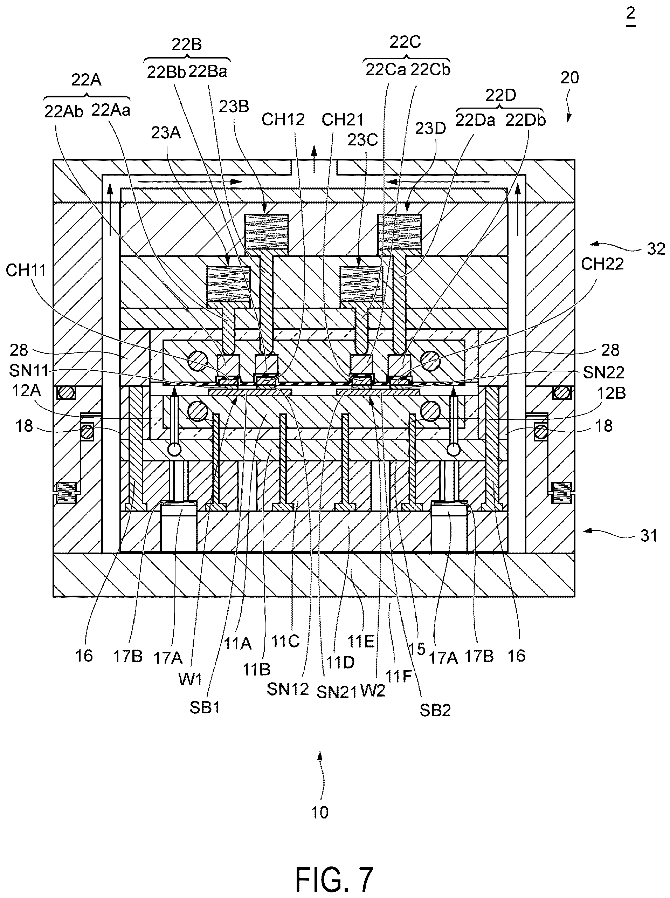

Next, the lower mold 10 and the upper mold 20 are further closed, and the movable mechanisms 22A, 22B, 22C, and 22D come into contact with the electronic components CH11, CH12, CH21, and CH22 via the film F (S21). As shown in FIG. 7, when the side blocks 18 and 28 of the lower mold 10 and the upper mold 20 come into contact with each other and the mold closing is completed, the set pin 16 is pushed down to the maximum. The movable piece 22Ab of the movable mechanism 22A comes into contact with the electronic component CH11 via the film F, and the spring 23A is compressed by the amount that the rod 22Aa of the movable mechanism 22A is pushed up. The movable piece 22Bb of the movable mechanism 22B comes into contact with the electronic component CH12 via the film F, and the spring 23B is compressed by the amount that the rod 22Ba of the movable mechanism 22B is pushed up. The movable piece 22Cb of the movable mechanism 22C comes into contact with the electronic component CH21 via the film F, and the spring 23C is compressed by the amount that the rod 22Ca of the movable mechanism 22C is pushed up. The movable piece 22Db of the movable mechanism 22D comes into contact with the electronic component CH22 via the film F, and the spring 23D is compressed by the amount that the rod 22Da of the movable mechanism 22D is pushed up.

Since the springs 23A, 23B, 23C, and 23D are independent of each other, the compression amount of the spring 23A is determined by the thicknesses of the substrate SB1, the bonding material SN11, and the electronic component CH11, and is substantially not affected by the thicknesses of the substrate SB2, the bonding materials SN12, SN21, and SN22, and the electronic components CH12, CH21, and CH22. That is, an insufficient or excessive pressure on the electronic component CH11 due to the influence of the thicknesses of the substrate SB2, the bonding materials SN12, SN21, and SN22, and the electronic components CH12, CH21, and CH22 is suppressed. Similarly, the compression amount of the spring 23B is determined by the thicknesses of the substrate SB1, the bonding material SN12, and the electronic component CH12, and is substantially not affected by the thicknesses of the substrate SB2, the bonding materials SN11, SN21, and SN22, and the electronic components CH11, CH21, and CH22. An insufficient or excessive pressure on the electronic component CH12 due to the influence of the thicknesses of the substrate SB2, the bonding materials SN11, SN21, and SN22, and the electronic components CH11, CH21, and CH22 is suppressed. The compression amount of the spring 23C is determined by the thicknesses of the substrate SB2, the bonding material SN21, and the electronic component CH21, and is substantially not affected by the thicknesses of the substrate SB1, the bonding materials SN11, SN12, and SN22, and the electronic components CH11, CH12, and CH22. An insufficient or excessive pressure on the electronic component CH21 due to the influence of the thicknesses of the substrate SB1, the bonding materials SN11, SN12, and SN22, and the electronic components CH11, CH12, and CH22 is suppressed. The compression amount of the spring 23D is determined by the thicknesses of the substrate SB2, the bonding material SN22, and the electronic component CH22, and is substantially not affected by the thicknesses of the substrate SB1, the bonding materials SN11, SN12, and SN21, and the electronic components CH11, CH12, and CH21. An insufficient or excessive pressure on the electronic component CH22 due to the influence of the thicknesses of the substrate SB1, the bonding materials SN11, SN12, and SN21, and the electronic components CH11, CH12, and CH21 is suppressed. The bonding materials SN11, SN12, SN21, and SN22 are simultaneously pressurized at an appropriate pressure via the electronic components CH11, CH12, CH21, and CH22. Depending on the electronic components to be mounted, some are resistant to pressure and some are not, and since the bonding material can also be changed depending on the electronic components to be mounted, some require a strong pressure and some require a weak pressure, and it is also possible to change the spring pressure for each of the springs 23A, 23B, 23C, and 23D.

With the movable mechanisms 22A, 22B, 22C, and 22D contacting the electronic components CH11, CH12, CH21, and CH22 via the film F, the adhesion between the cavity plate 11A of the lower mold 10 and the substrates SB1 and SB2 is improved. For this reason, compared to Step S16 in which the substrates SB1 and SB2 are placed on the cavity plate 11A, the efficiency of thermal conduction from the lower mold 10 to the substrates SB1 and SB2 is improved, and the heating efficiency of the bonding materials SN11, SN12, SN21, and SN22 by the lower mold 10 is improved. In addition, the electronic components CH11, CH12, CH21, and CH22 are heated by thermal conduction from the movable pieces 22Ab, 22Bb, 22Cb, and 22Db of the upper mold 20. For this reason, compared to Steps S13 to S16 in which the electronic components CH11, CH12, CH21, and CH22 are heated by thermal radiation, the heating efficiency of the bonding materials SN11, SN12, SN21, and SN22 by the upper mold 20 is improved. As shown in FIG. 4, the temperature of the workpieces W1 and W2 at this time is raised from the preheating temperature of 100°C to 150°C to the sintering process temperature of 250°C to 300°C.

The bonding materials SN11, SN12, SN21, and SN22 are sintered by heating and pressurizing. The sintered bonding material SN11 bonds and electrically connects the electronic component CH11 and the substrate SB1, the sintered bonding material SN12 bonds and electrically connects the electronic component CH12 and the substrate SB1, the sintered bonding material SN21 bonds and electrically connects the electronic component CH21 and the substrate SB2, and the sintered bonding material SN22 bonds and electrically connects the electronic component CH22 and the substrate SB2. That is, the electronic components CH11 and CH12 are mounted on the substrate SB1, and the electronic components CH21 and CH22 are mounted on the substrate SB2.

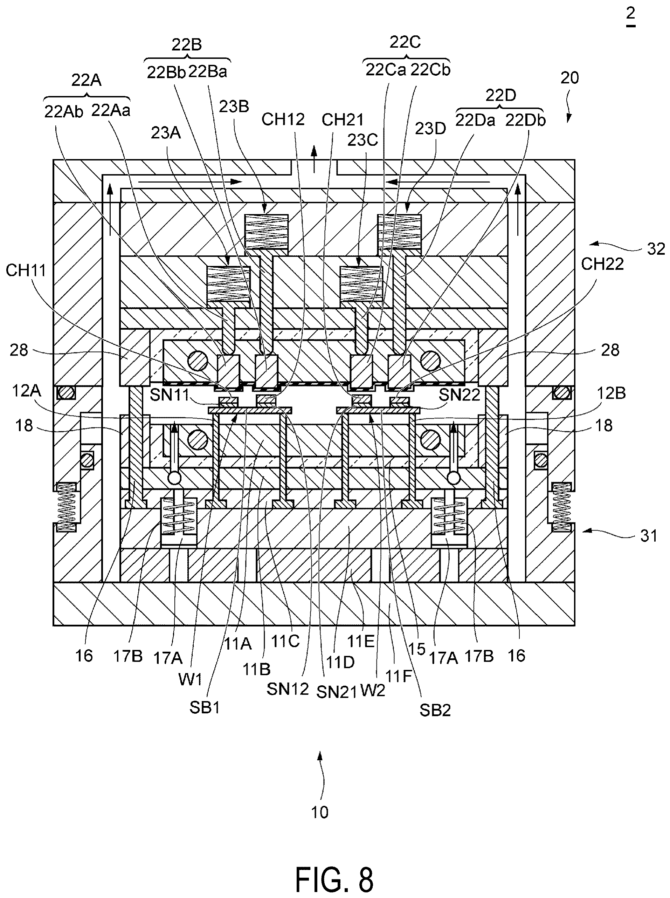

Next, with the mold opening being performed, the lifter pins 12A, 12B are raised, and the substrates SB1, SB2 are separated from the cavity plate 11A of the lower mold 10 (S22). As shown in FIG. 8, the side block 28 of the upper mold 20 is separated from the side block 18 of the lower mold 10. The spring 17B exerts an elastic force in a direction that causes the ejector pin plate 11C to approach the lower mold chase 11B to which the base end part of the spring sleeve 17A (the side where the shoulder bolt is screwed, the upper side) is screwed. Since the position of the lower mold chase 11B is fixed by the support pillar 11E, the ejector pin plate 11C and the retainer plate 11D connected to the ejector pin plate 11C are pushed upward. As a result, the ejector pin plate 11C and the retainer plate 11D are raised, and the lifter pins 12A, 12B whose base end parts are sandwiched between the ejector pin plate 11C and the retainer plate 11D are also raised. The tip end parts of the lifter pins 12A, 12B protrude from the cavity plate 11A and abut against the back surfaces of the substrates SB1, SB2, and the workpieces W1, W2 are separated from the cavity plate 11A. The gas supply port 13 supplies nitrogen gas toward the workpieces W1, W2. Cooling of the workpieces W1, W2 is started by separating the workpieces W1, W2 from the cavity plate 11A, which is the heat source, and receiving the supply of nitrogen gas. As shown in FIG. 4, the temperature of the workpieces W1, W2 at this time is approximately 250°C to 300°C, which is the sintering process temperature.

Next, the supply of nitrogen gas is stopped, and degassing is stopped (S23). As shown in FIG. 4, at the stage when the workpieces W1 and W2 are cooled to approximately 100°C to 150°C, the supply of nitrogen gas from the gas supply port 13 is stopped, and thereafter, degassing from the degassing port 29 is stopped. As a result, cooling of the workpieces W1 and W2 in the mounting device 1 is completed.

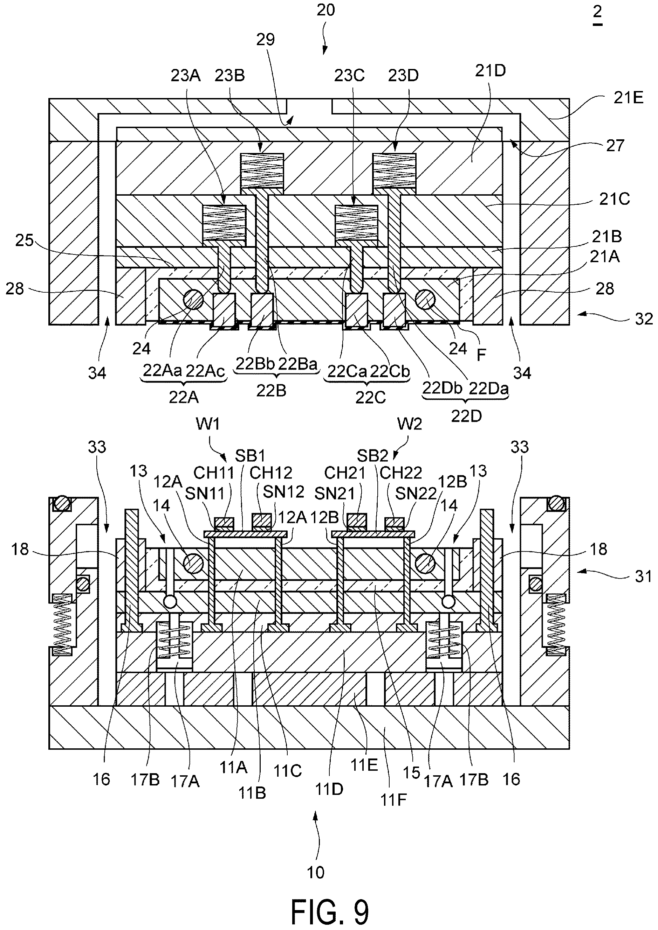

Finally, by further opening the mold, the degassing chambers 31 and 32 are opened, and the workpieces W1 and W2 are taken out (S24). As shown in FIG. 9, the degassing chamber 31 and the degassing chamber 32 are separated, and the workpieces W1 and W2 are opened. The workpieces W1 and W2 are recovered from above the lifter pins 12A and 12B.

In the embodiment, a configuration in which one electronic component is pressurized by one movable mechanism and one movable mechanism is moved by one elastic element has been described as an example, but the embodiments according to the invention are not limited thereto.

For example, multiple electronic components may be pressurized by one movable mechanism. In such configuration, when the heights of the electronic components differ, unevenness corresponding to the heights of the electronic components may be provided on the tip end surfaces of the movable pieces. In this way, multiple electronic components having different heights can be pressurized with a substantially uniform pressure by one movable mechanism. Also, one electronic component may be pressurized by multiple movable mechanisms. In this way, even in the case where one electronic component includes portions of different heights, by pressurizing with a different movable mechanism for each portion, the entirety of one electronic component can be pressurized with a substantially uniform pressure. Also, for example, one movable mechanism may be moved by multiple elastic elements, and multiple movable mechanisms may be moved by one elastic element. The movable mechanisms are arranged side-by-side on the paper surface of the drawing, for example, but may be arranged side-by-side in the depth direction of the paper surface. The movable mechanisms may be arranged in a matrix so as to pressurize the respective electronic components arranged in a matrix with respect to the substrate.

Also, in the embodiment, a configuration in which the upper mold has two support plates (lower support plate and upper support plate) and two closest elastic elements are provided on mutually different support plates has been described as an example, but the embodiments according to the invention are not limited thereto.

If the two closest elastic elements can be provided on one support plate, the upper mold may have only one support plate. At this time, the two closest elastic elements may be provided side-by-side in a direction intersecting the opening and closing direction of the lower mold and the upper mold, or may be provided so that parts of each other overlap in the opening and closing direction of the lower mold and the upper mold. For example, an upper surface concave part opening on the upper surface and a lower surface concave part opening on the lower surface of one support plate may be provided, the upper surface concave part and the lower surface concave part partially overlap each other in the upper-lower direction, and elastic elements may be arranged inside the upper surface concave part and the lower surface concave part, respectively. Also, the upper mold may have three or more support plates, and elastic elements may be provided on each support plate. In this way, compared to a configuration in which the number of support plates provided on the upper mold is two, the elastic elements and the movable mechanisms can be provided more densely, so that each of the more densely arranged electronic components can be pressurized simultaneously and individually with an appropriate pressure.

Hereinafter, a part or all of the embodiments of the invention will be additionally described. The invention is not limited to the following additional descriptions.

### . [Appendix 1]

A mounting device for mounting one or more electronic components on at least one substrate includes: a first mold, configured to hold the substrate on which the electronic component is placed; a second mold, disposed opposite to the first mold; and a gas supply mechanism, supplying inert gas to a space between the first mold and the second mold. The second mold includes a movable mechanism and an elastic element, and, in a state where the first mold and the second mold are closed, the electronic component is pressurized by the movable mechanism according to an elastic force of the elastic element.

According to the embodiment, an elastic force is generated in the elastic element through the upward movement of the movable mechanism according to the height of the electronic components and the substrate, and the electronic component is pressurized by the elastic force. That is, the elastic force suitable for pressurizing the electronic component is naturally generated within the mold. Therefore, compared to mounting device that pressurizes the electronic component via a fluid supplied from outside the second mold, miniaturization can be achieved. Also, the gas supply mechanism excludes oxidizing gas from around the electronic component and the substrate, and makes the surroundings of the electronic component and the substrate an inert gas atmosphere. Accordingly, bonding defects due to oxidation of the bonding material that bonds the electronic component to the substrate can be suppressed, and a bonding process at a high temperature can be performed. Also, at the time of cooling the electronic component and the substrate after the bonding process, the electronic component and the substrate can be gas-cooled by the inert gas.

### [Appendix 2]

In the mounting device according to [Appendix 1], the second mold includes multiple movable mechanisms and multiple elastic elements, and the respective movable mechanisms are independently movable by elastic elements different from each other.

According to the embodiment, the elastic force of one elastic element is determined based on the thickness of one electronic component and the required pressure, and is substantially unaffected by the thickness of other electronic components or the required pressure. Therefore, an insufficient or excessive pressure on the one electronic component due to the influence of the thickness of the other electronic components or the required pressure is suppressed. That is, each of the electronic components can be simultaneously and individually pressurized with an appropriate pressure.

### [Appendix 3]

In the mounting device according to [Appendix 2], the second mold includes multiple support plates, and at least two of the elastic elements are provided on support plates different from each other.

According to the embodiment, the two elastic elements can be arranged so that portions of the two elastic elements overlap with a gap therebetween in the opening and closing direction of the first mold and the second mold. That is, the elastic elements can be densely arranged. Therefore, even when the electronic components are densely arranged, the respectively electronic components can be simultaneously and individually pressurized with appropriate pressures.

### [Appendix 4]

In the mounting device according to any one of [Appendix 1] to [Appendix 3], the gas supply mechanism includes a gas supply port provided on at least one of the first mold and the second mold and supplying the inert gas toward the electronic component and the substrate.

According to the embodiment, inert gas can be directly blown onto the electronic component and the substrate from the gas supply port facing the electronic component and the substrate. At the time of heating the electronic component and the substrate, the surroundings of the electronic component and the substrate can be efficiently made into an inert gas atmosphere. Therefore, bonding defects due to oxidation of the bonding material can be suppressed. Also, at the time of cooling the electronic component and the substrate, by applying inert gas to the electronic component and the substrate, the surroundings of the electronic component and the substrate can be efficiently gas-cooled. Since the cooling rate of the mounted product is improved, the time required to remove the mounted product from the mounting device is shortened, and production efficiency can be improved.

### [Appendix 5]

The mounting device according to any one of [Appendix 1] to [Appendix 4] further includes: a degassing chamber, being openable and closable and surrounding the first mold and the second mold.

According to the embodiment, since the surroundings of the electronic component and the substrate can be made into a vacuum atmosphere or an inert gas atmosphere, oxidation can be suppressed. Therefore, multiple electronic components and at least one substrate can be heated to high temperature.

### [Appendix 6]

In the mounting device according to any one of [Appendix 1] to [Appendix 5], the movable mechanism includes a movable piece that applies an elastic force transmitted from the elastic element to the electronic component, and the second mold further includes: a heater, heating the movable piece; and a heat insulation member, partitioning the heater and the elastic element.

According to the embodiment, when the heater heats the movable piece, the temperature rise of the elastic element can be suppressed. Therefore, property changes and damages of the elastic element due to heat can be suppressed.

### [Appendix 7]

In the mounting device according to any one of [Appendix 1] to [Appendix 6], the elastic element is a coil spring formed by using a metal material.

### [Appendix 8]

In the mounting device according to any one of [Appendix 1] to [Appendix 7], the mounting device is a sintering device.

### [Appendix 9]

A mounting method using a mounting device for mounting one or more electronic components on at least one substrate includes: preparing a first mold configured to hold the substrate on which the electronic component is placed; and preparing a second mold disposed opposite to the first mold. In addition, the second mold has a movable mechanism and an elastic element. The mounting method further includes: supplying an inert gas to a space between the first mold and the second mold; closing the first mold and the second mold; and in a state where the first mold and the second mold are closed, pressurizing the electronic component by the movable mechanism according to an elastic force of the elastic element.

According to the embodiment, the upward movement of the movable mechanism in accordance with the heights of the electronic component and the substrate causes an elastic force to be generated in the elastic element, and the electronic component is pressurized by the elastic force. In other words, an elastic force suitable for pressurizing the electronic component is naturally generated within the mold. Therefore, size reduction can be achieved compared to the mounting device that pressurizes the electronic component via a fluid supplied from outside the second mold. In addition, the gas supply mechanism removes the oxidizing gas from around the electronic component and the substrate, and creates an inert gas atmosphere around the electronic component and the substrate. This suppresses bonding defects caused by oxidation of the bonding material that bonds the electronic component to the substrate, and enables a bonding process at a high temperature. Furthermore, at the time of cooling the electronic component and the substrate after the bonding process, the electronic component and the substrate can be gas-cooled by the inert gas.

As described above, it is possible to provide a compact mounting device capable of suppressing the occurrence of mounting defects, and a mounting method using the same.

The embodiments described above are intended to facilitate understanding of the invention and are not intended to limit the interpretation of the invention. Each element included in the embodiments, as well as their arrangement, materials, conditions, shapes, sizes, and the like, are not limited to those illustrated and can be changed as appropriate. In addition, configurations shown in different embodiments can be partially substituted or combined with each other.

### [Reference Signs List]

1...mounting device
10...lower mold
11A...cavity plate
11B...lower mold chase
11C...ejector pin plate
11D... retainer plate
11E...support pillar
11F...lower mold base
12A, 12B...lifter pin
13...gas supply port
14...heater
15...heat insulation member
16...set pin
17A...spring sleeve
17B...spring
18...side block
20...upper mold
21A...cavity plate
21B...upper mold chase
21C...lower support plate
21D...upper support plate
21E...upper mold base
22A, 22B, 22C, 22D...movable mechanism
22Aa, 22Ba, 22Ca, 22Da...rod
22Ab, 22Bb, 22Cb, 22Db...movable piece
23A, 23B, 23C, 23D...spring
24...heater
25...heat insulation member
27...degassing path
28...side block
29...degassing port
31, 32...degassing chamber
33, 34...degassing path

## Claims

1. A mounting device for mounting one or more electronic components on at least one substrate, the mounting device comprising:
a first mold, configured to hold the substrate on which the electronic component is placed;
a second mold, disposed opposite to the first mold; and
a gas supply mechanism, supplying inert gas to a space between the first mold and the second mold, wherein:
the second mold comprises a movable mechanism and an elastic element, and
in a state where the first mold and the second mold are closed, the electronic component is pressurized by the movable mechanism according to an elastic force of the elastic element.

2. The mounting device as claimed in claim 1, wherein:
the second mold comprises a plurality of the movable mechanisms and a plurality of the elastic elements, and
the respective movable mechanisms are independently movable by elastic elements different from each other.

3. The mounting device as claimed in claim 2, wherein:
the second mold comprises a plurality of support plates, and
at least two of the elastic elements are provided on support plates different from each other.

4. The mounting device as claimed in claim 1, wherein:
the gas supply mechanism comprises a gas supply port provided on at least one of the first mold and the second mold and supplying the inert gas toward the electronic component and the substrate.

5. The mounting device as claimed in claim 1, further comprising:
a degassing chamber, being openable and closable and surrounding the first mold and the second mold.

6. The mounting device as claimed in claim 1, wherein:
the movable mechanism comprises a movable piece that applies an elastic force transmitted from the elastic element to the electronic component, and
the second mold further comprises:
a heater, heating the movable piece; and
a heat insulation member, partitioning the heater and the elastic element.

7. The mounting device as claimed in claim 1, wherein:
the elastic element is a coil spring formed by using a metal material.

8. The mounting device as claimed in any one of claims 1 to 7, wherein the mounting device is a sintering device.

9. A mounting method, using a mounting device for mounting one or more electronic components on at least one substrate, the mounting method comprising:
preparing a first mold configured to hold the substrate on which the electronic component is placed; and
preparing a second mold disposed opposite to the first mold,
wherein the second mold has a movable mechanism and an elastic element, and
the mounting method further comprises:
supplying an inert gas to a space between the first mold and the second mold;
closing the first mold and the second mold; and
in a state where the first mold and the second mold are closed, pressurizing the electronic component by the movable mechanism according to an elastic force of the elastic element.
